# FASCICULE DE BREVET EUROPEEN

(11) **EP 4 239 885 B1**
(45) Date de publication et mention de la délivrance du brevet: **18.09.2024**
(21) Numéro de dépôt: 23158686.8
(22) Date de dépôt: 27.02.2023
(51) Int. Cl.: H03K 17/04, H03K 17/0412

(54) **PILOTE POUR TRANSISTOR A GRILLE ISOLEE AVEC CIRCUIT DE COMPENSATION DES TEMPS DE RETARD**
TREIBER FÜR EINEN TRANSISTOR MIT ISOLIERTEM GATE MIT VERZÖGERUNGSZEITKOMPENSATIONSSCHALTUNG
DRIVER FOR INSULATED GATE TRANSISTOR WITH DELAY COMPENSATION CIRCUIT

(30) Priorité: 02.03.2022 FR 2201807
(43) Date de publication de la demande: 06.09.2023
(73) Titulaire: Safran Electrical & Power, 31700 Blagnac (FR)
(72) Inventeur: ABDESSELAM, Francis, 78400 CHATOU (FR)
(74) Mandataire: Atout PI Laplace

(56) Documents cités:
- JP-A- H11 262 243
- JP-B2- 5 736 243
- US-A1- 2011 273 206
- US-A1- 2017 179 944

## Description

Le domaine de l'invention est celui des commandes de module d'électronique de puissance permettant de piloter le fonctionnement de composants électroniques de puissance. De manière connue, les modules de puissance comprennent des composants électroniques traitant de fortes puissances et présentent, de ce fait, une attention particulière dans leur conception et leur suivi en cours de vie et d'utilisation. US 2017/179944 A1 est considéré comme une antériorité pertinente et divulgue un circuit de commande pour un transistor de puissance illustrant une approche de l'égalisation des commutateurs de puissance à l'aide d'un circuit de temps de retard.

Plus précisément, l'invention a trait au contrôle des composants électroniques de puissance et à la gestion du retard entre une commande émise par un pilote (« driver » en anglais) du composant d'électronique de puissance et la réponse du composant de puissance par rapport à la commande émise.

De manière connue, l'initialisation d'une ouverture d'un composant d'électronique de puissance ou l'initialisation d'une fermeture de ce composant d'électronique de puissance n'est pas immédiat suite à l'émission de cette commande du pilote associé. En effet, un composant d'électronique de puissance nécessite par exemple une certaine durée afin de se charger ou de se décharger, ou encore afin d'induire la tension nécessaire à la grille du composant d'électronique de puissance en accord avec la commande émise par le pilote. Dès lors, des retards peuvent être observés, liés par exemple à la charge ou à la décharge du composant d'électronique de puissance. Une commande en provenance du pilote induit également, par exemple en commandant une ouverture ou une fermeture du composant d'électronique de puissance, une croissance ou un décroissance de la tension et du courant traversant le composant d'électronique de puissance. Or, les variations de la tension et du courant qui en découlent sont, au moins partiellement, dépendant du temps nécessaire au composant de puissance pour répondre à la commande qui lui est donnée. Dès lors, réduire le retard nécessaire à la réponse du composant d'électronique de puissance suite à une commande du pilote augmente la variation du courant et de tension que subit le composant d'électronique de puissance. Une variation de tension et/ou de courant trop importante peut détériorer le composant d'électrique de puissance voire le détruire. Dès lors la gestion, et particulièrement la compensation, du retard du composant de puissance suite à une commande tout en n'impactant pas ou peu la variation du courant et de tension que le composant de puissance subit lors de l'initialisation de la commande est une problématique importante.

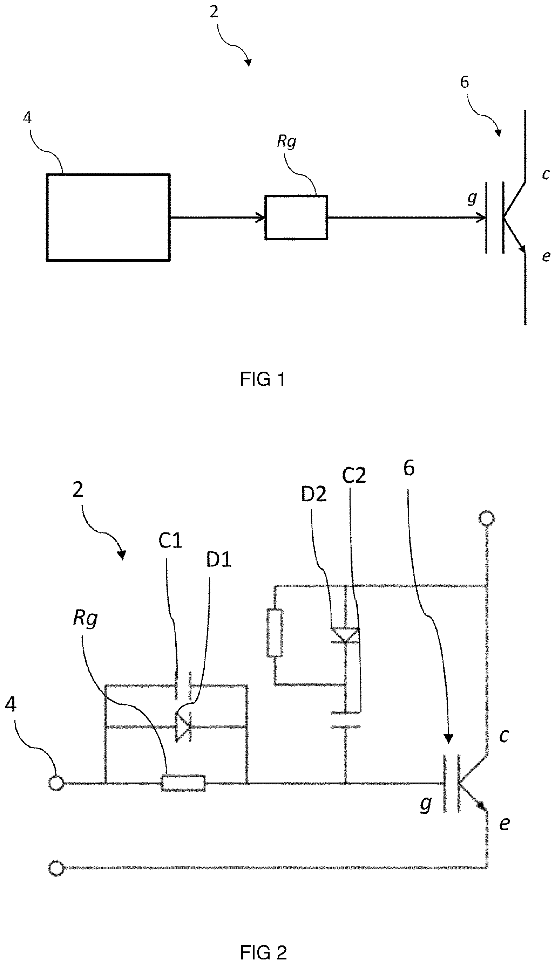

La figure 1 représente un étage de puissance 2 comprenant un pilote 4 et un transistor de puissance 6 piloté par le pilote 4. Le transistor de puissance 6 est composant semi-conducteur composé de trois bornes : un collecteur c, un émetteur e et une grille g reliée au pilote 6. Le transistor de puissance de puissance 6 est un transistor bipolaire à grille isolée (IGBT, de l'anglais *Insulated Gate Bipolar Transistor*)*.* En variante, le transistor de puissance 6 est un transistor à effet de champ (en anglais, *métal oxide semiconductor Field-effect transistor* ou *MOSFET*) et comprend donc un drain, une source et une grille reliée au pilote 4. Dès lors, pour un transistor à effet de champ, le drain peut être assimilé au collecteur c, la source peut être assimilée à l'émetteur e. De manière générale, la gestion des retards entre l'émission de la commande du pilote 4 et la réaction, par exemple l'initialisation d'une ouverture ou d'une fermeture, du transistor de puissance 6 n'est pas prise en considération et seule une résistance de la grille Rg est positionnée entre le pilote 4 et la grille g du transistor de puissance 6.

Il a ainsi été envisagé, comme représenté en figure 2, afin de réduire la croissance de la tension et la décroissance du courant traversant le composant d'électronique de puissance à l'ouverture du transistor de puissance 6 par exemple, de positionner :
- en dérivation de la résistance de la grille Rg, une première diode passante D1 ainsi qu'un premier condensateur C1, tous deux en dérivation, c'est-à-dire formant deux boucles électrique distinctes, l'un par rapport à l'autre. On comprend par diode passante que la diode laisse passer le courant, lorsque l'anode de la diode fait face au sens du courant, en direction de la grille g du transistor de puissance 6. En effet, le premier condensateur C1 devant être chargé, une grande différence de tension est observable entre la tension à la commande et la tension au premier condensateur C1. Dès lors, un courant dérivé de la résistance de la grille Rg peut être observé avec une redirection du courant, en provenance du pilote, vers le premier condensateur C1 et vers la première diode passante D1. Le courant dérivé de la résistance de la grille Rg est effectif jusqu'à ce que le premier condensateur C1 soit complètement chargé. Dès lors, le premier condensateur C1 se transforme en un interrupteur ouvert et le courant dérivé disparait.
- une deuxième diode passante D2 en série d'un deuxième condensateur C2 reliant le collecteur c à la grille g du transistor de puissance 6. De plus une deuxième résistance R2 est positionnée en dérivation de la deuxième diode passante D2.

Il est également possible de réduire la décroissance de la tension et la croissance du courant traversant le composant d'électronique de puissance à la fermeture du transistor de puissance 6 en échangeant la première diode passante D1 et la deuxième diode passante D2 par des diodes bloquantes, c'est-à-dire des diodes empêchant le courant de circuler en direction de la grille g du transistor de puissance 6, lorsque la cathode de la diode fait face au sens du courant.

Néanmoins, ces solutions présentent des retards inhérents au premier ordre, à l'équivalent capacitif du transistor de puissance, liés à l'ouverture et/ou la fermeture du composant d'électronique de puissance.

En effet, lors de l'ouverture ou de la fermeture du transistor de puissance, des retards peuvent être identifiés :
- Un délai t1 entre la commande d'ouverture émise par le pilote et la diminution de la tension au collecteur du transistor de puissance Vc.
- Un délai t2 pour observer la saturation du transistor de puissance à grille isolée.
- Un délai t3 associé à l'augmentation de la tension à la grille Vg pour atteindre la valeur maximale Vgmax imposée par la commande du pilote 4.
- Un délai t4 entre la commande de fermeture émise par le pilote et l'augmentation de la tension au collecteur du transistor de puissance Vc.
- Un délai t5 pour observer le retard à la désaturation du transistor de puissance.
- Un délai t6 associé à la diminution de la tension à la grille Vg pour atteindre la valeur minimale Vgmin imposée par la commande du pilote 4.
- Un délai tf qui représente le temps nécessaire à la décroissance de la tension au collecteur Vc, c'est-à-dire le passage d'une tension équivalente à 90% de la tension maximale au collecteur Vcmax à une tension équivalente à 10% de la tension maximale au collecteur Vcmax.
- Un délai tr qui représente le temps nécessaire à la croissance de la tension au collecteur Vc, c'est-à-dire le passage d'une tension équivalente à 1 0% de la tension maximale au collecteur Vcmax à une tension équivalente à 90% de la tension maximale au collecteur Vcmax.

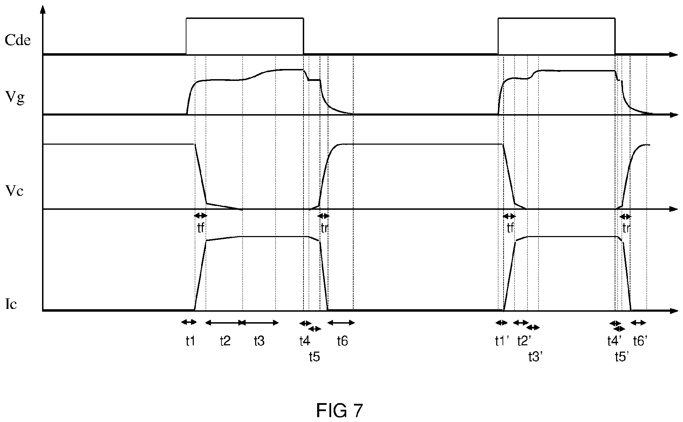

Les délais t1, t2, t3, t4, t5, t6 sont représentés en figure 7.

Ainsi, lors d'une initialisation d'une ouverture du transistor de puissance, les délais t1, tf, t2 et t3 se succèdent augmentant significativement le temps nécessaire à l'initialisation de l'ouverture du transistor de puissance. De manière similaire, les délais t4, t5, tr et t6 se succèdent également lors de la fermeture du transistor de puissance.

L'invention vise à pallier tout ou partie des problèmes cités plus haut en proposant un dispositif de compensation des retards purs liés à l'initialisation du transistor de puissance en réponse à une commande en provenance du pilote qui présente également l'avantage de ne pas modifier et/ou induire une variation de tension et/ou de courant rapide pouvant dégrader le transistor de puissance. Plus précisément, l'invention permet de réduire les délais t1, t2, t3, t4, t5 et t6 sans impacter les délais tf et tr permettant de conserver les mêmes variations de tension et de courant et de ne pas augmenter les perturbations électromagnétiques.

A cet effet, l'invention a pour objet un étage de puissance comprenant un transistor de puissance et un pilote, le transistor de puissance comprenant un collecteur, une grille et un émetteur, le transistor de puissance étant configuré pour basculer d'un état dit saturé à un état dit bloqué et vice versa selon une commande du pilote, l'étage de puissance comprenant un résistance Rg positionnée entre le pilote et la grille du transistor de puissance, l'étage de puissance comprenant un circuit de compensation des retards positionné en dérivation de la résistance Rg, le circuit de compensation des retards comprenant :
- un circuit de compensation de retards d'initialisation de conduction, configuré pour dériver le courant la résistance Rg lors d'une initialisation d'une saturation du transistor de puissance,
- un circuit de compensation de retards d'initialisation d'arrêt de conduction, configuré pour dériver le courant la résistance Rg lors d'une initialisation d'un blocage du transistor de puissance,
- un circuit de compensation de retards configuré pour dériver le courant la résistance Rg lorsque le transistor de puissance est proche de l'état saturé.

Selon un aspect de l'invention, le circuit de compensation de retards d'initialisation de conduction comprend :
- Une première diode de signal configurée pour recevoir par son anode un signal de commande du pilote,
- Un premier transistor de signal relié à la cathode de la diode de signal par l'intermédiaire d'un émetteur du premier transistor de signal, le transistor de signal comprenant une base et un collecteur relié à la grille du transistor de puissance,
- Une première résistance, reliée à l'émetteur du premier transistor de signal et à la base du premier transistor de signal,
- Un premier condensateur de signal relié à la base du premier transistor de signal et à la grille du transistor de puissance.

Selon un aspect de l'invention, le premier transistor de signal est un transistor bipolaire PNP.

Selon un aspect de l'invention, le premier transistor de signal est un transistor MOSFET canal P.

Selon un aspect de l'invention, le circuit de compensation de retards d'initialisation de d'arrêt de conduction comprend :
- Un deuxième transistor de signal relié à la grille du transistor de puissance par l'intermédiaire d'un collecteur du deuxième transistor de signal, le deuxième transistor de signal comprenant une base et un émetteur,
- Une deuxième diode de signal reliée par sa cathode au pilote et par son anode à l'émetteur du deuxième transistor de signal,
- Une deuxième résistance, reliée à l'émetteur du deuxième transistor de signal et à la base du deuxième transistor de signal,
- Un deuxième condensateur de signal relié à la grille du transistor de puissance et à la base du deuxième transistor de signal.

Selon un aspect de l'invention, le deuxième transistor de puissance est un transistor bipolaire NPN.

Selon un aspect de l'invention, le deuxième transistor de puissance est un transistor MOSFET canal N.

Selon un aspect de l'invention, le circuit de compensation de retards liés à la charge et/ou la décharge du transistor de puissance comprend :
- Une troisième diode de signal configurée pour recevoir par son anode un signal de commande du pilote,
- Un troisième transistor de signal relié à la cathode de la troisième diode de signal par l'intermédiaire d'un émetteur du troisième transistor de puissance, le troisième transistor de signal comprenant une base et un collecteur relié à la grille du transistor de puissance,
- Une troisième résistance reliée à la base du troisième transistor de signal et à l'émetteur du troisième transistor de signal,
- Une diode reliée par sa cathode au collecteur du transistor de puissance et par son anode à la base du troisième transistor de signal par l'intermédiaire d'un troisième condensateur de signal et d'une quatrième résistance, le troisième condensateur de signal et la quatrième résistance étant positionnés en dérivation l'un par rapport à l'autre.

L'invention sera mieux comprise et d'autres avantages apparaîtront à la lecture de la description détaillée d'un mode de réalisation donné à titre d'exemple, description illustrée par le dessin joint dans lequel :
[Fig.1] la figure 1 représente un étage de puissance comprenant un pilote et un transistor de puissance selon l'état de l'art ;
[Fig.2] la figure 2 représente l'étage de puissance comprenant le pilote, le transistor de puissance et un circuit de régulation à l'ouverture du transistor de puissance selon l'état de l'art ;
[Fig.3] la figure 3 représente un étage de puissance comprenant un pilote, un transistor de puissance et un circuit de compensation des retards lié à l'initialisation du transistor de puissance selon l'invention ;
[Fig.4] la figure 4 représente une architecture d'un circuit de compensation de retards d'initialisation de conduction du circuit de compensation des retards du transistor de puissance selon l'invention ;
[Fig.5] la figure 5 représente une architecture d'un circuit de compensation de retards configuré pour dériver le courant de la résistance Rg lorsque le transistor de puissance est proche de l'état saturé ;
[Fig.6] la figure 6 représente une architecture d'un circuit de compensation de retards d'initialisation d'arrêt de conduction du circuit de compensation des retards du transistor de puissance selon l'invention ;
[Fig.7] la figure 7 représente un chronogramme comparant les retards d'un transistor de puissance en réponse à une commande selon l'état de l'art et les retards d'un transistor de puissance en réponse à une commande selon l'invention.

Par souci de clarté, les mêmes éléments porteront les mêmes repères dans les différentes figures.

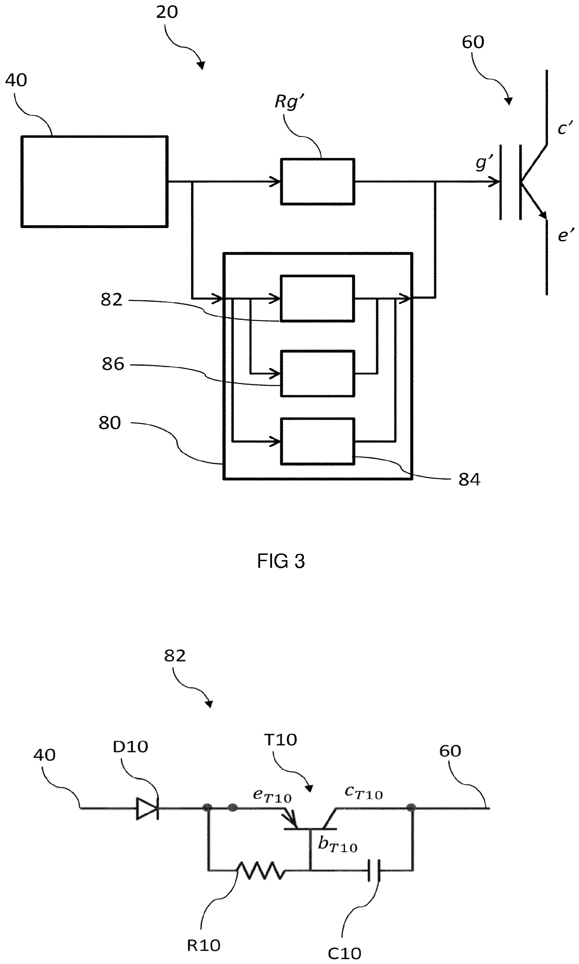

La figure 3 représente un étage de puissance 20 selon l'invention, comprenant un transistor de puissance 60 et un pilote 40. Le transistor de puissance 60 est un transistor bipolaire à grille isolée comprend un collecteur c', un émetteur e' et une grille g'. Le transistor de puissance 60 est configuré pour basculer d'un état dit saturé à un état dit bloqué et vice versa selon une commande du pilote 40. L'étage de puissance 20 comprend également une résistance Rg' positionnée entre le pilote 40 et la grille *g*'du transistor de puissance 60.

L'étage de puissance 20 comprend un circuit de compensation 80 des retards positionné en dérivation de la résistance Rg' comprenant un circuit de compensation de retards d'initialisation de conduction 82, configuré pour dériver le courant de la résistance Rg' lors d'une initialisation d'une saturation du transistor de puissance 60. Le circuit de compensation de retards d'initialisation de conduction 82 permet ainsi de limiter le délai lié à l'initialisation d'une ouverture du transistor de puissance 60 et précisément les délais t1 et/ou t3.

Le circuit de compensation 80 comprend également un circuit de compensation de retards d'initialisation d'arrêt de conduction 84, configuré pour dériver le courant de la résistance Rg' lors d'une initialisation d'un blocage du transistor de puissance 60. Le circuit de compensation de retards d'initialisation d'arrêt de conduction 84 présente ainsi l'avantage de réduire le délai lié à l'initialisation d'une fermeture du transistor de puissance 60 et précisément les délais t4 et/ou t6. En outre, le circuit de compensation de retards d'initialisation d'arrêt de conduction 84 est positionné en dérivation par rapport au circuit de compensation de retards d'initialisation de conduction 82.

De plus, le circuit de compensation 80 des retards comprend un circuit de compensation de retards 86 configuré pour dériver le courant de la résistance Rg' lorsque le transistor de puissance 60 est proche de l'état saturé, c'est-à-dire pour une tension inférieur à 10 Volts et réduire les délais t2 et/ou t5. Le circuit de compensation de retards 86 est également positionné en dérivation du circuit de compensation de retards d'initialisation de conduction 82 et du circuit de compensation de retards d'initialisation d'arrêt de conduction 84.

Afin de limiter le délai t1 entre l'initialisation à l'ouverture du transistor de puissance de la commande du pilote et la diminution de la tension au collecteur du transistor de puissance Vc et le délai t3 associé à l'augmentation de la tension à la grille Vg pour atteindre la valeur maximale Vgmax imposée par la commande du pilote 40, le circuit de compensation de retards d'initialisation de conduction comprend, comme représenté en figure 4 :
- Une première diode de signal D10 configurée pour recevoir, par son anode, un signal de commande du pilote 40. La première diode de signal D10 est passante par rapport au sens du courant en direction de la grille *g'*du transistor de puissance 60.

Le circuit de compensation de retards d'initialisation de conduction 82 comprend un premier transistor de signal T10 relié à la cathode de la première diode de signal D10 par l'intermédiaire d'un émetteur *e*_{*T*10} du premier transistor de signal T10. Le transistor de signal T10 comprend également une base *b*_{*T*10} et un collecteur *c*_{*T*10} relié à la grille *g'* du transistor de puissance 60.

Le circuit de compensation de retards d'initialisation de conduction 82 comprend également une première résistance R10, reliée à l'émetteur *e*_{*T*10} du premier transistor de signal T10 et à la base *b*_{*T*10} du premier transistor de signal T10 et un premier condensateur de signal C10 relié à la base *b*_{*T*10} du premier transistor de signal et à la grille *g'*du transistor de puissance 60.

La première diode D10 permet ainsi la circulation du courant en provenance du pilote 40 dans un unique sens, en direction de la grille *g'*du transistor de puissance 60.

Le premier transistor de signal T10 est un transistor bipolaire PNP. Ainsi, le courant en provenance du pilote 40 traverse la première diode de signal D10 avant de se diriger vers l'émetteur *e*_{*T*10} du premier transistor de signal T10. Or, le premier condensateur de signal C10 étant déchargé, un fort différentiel de tension est observable entre l'armature du premier condensateur de signal C10 faisant face au courant dans le sens du courant, c'est-à-dire en direction de la grille *g'*du transistor de puissance 60, et le pilote 40. Dès lors, le courant est dirigé vers cette armature du condensateur C10 et traverse ainsi l'émetteur *e*_{*T*10} et la base *b*_{*T*10} du premier transistor de signal T10.

Le courant traverse ainsi le premier transistor de signal T10 et ressort par l'intermédiaire de la base *b*_{*T*10} et du collecteur *c*_{*T*10} afin de se diriger respectivement vers le premier condensateur de signal C10 et vers la grille *g'* du transistor de puissance 60. Or, pour rappel, le circuit de compensation de retards d'initialisation de conduction 82 est positionné en dérivation par rapport à la résistance de grille *Rg'* comme représenté en figure 3, le circuit de compensation de retards d'initialisation de conduction 82 permet ainsi une redirection du courant en provenance du pilote 40 de sorte à dériver le courant de la résistance de grille *Rg'* pendant le chargement du premier condensateur de signal C10. En outre, la résistance équivalente formé par l'association de la résistance de grille *Rg'* et le circuit de compensation de retards d'initialisation de conduction 82 présente une résistance au courant inférieure à la seule résistance de la grille *Rg'* permettant d'apporter plus de courant du pilote 40 au transistor de puissance 60. Dès lors, la grille g'du transistor de puissance 60 reçoit plus de courant en provenance du pilote 40 et, permet ainsi une initialisation d'une ouverture du transistor de puissance dans un temps réduit par rapport à une configuration comme représentée en figure 1 et 2.

Cet appel de courant et redirection du courant en direction du circuit de compensation de retards d'initialisation de conduction 82 et en direction de la grille *g*' du transistor de puissance 60 cesse une fois le premier condensateur de signal C10 pleinement chargé. De plus, nous pouvons observer qu'avantageusement, lorsque le premier condensateur de signal C10 est pleinement chargé et que le courant dérivé cesse, la tension mesurée au collecteur du transistor de puissance Vc est une tension équivalente à 10% de la tension maximale au collecteur Vcmax. Ainsi, le transistor de puissance est ouvert dans un délai réduit.

En outre, la première diode de signal D10, le premier transistor de signal T10, la première résistance R10 ainsi que le premier condensateur de signal C10 sont des composants de faible niveau, c'est-à-dire des composants électroniques simples du marché. A titre d'exemple indicatif, la première diode de signal D10 est une diode signal 1 A/50V, le premier transistor de signal T10 est un transistor signal bipolaire PNP 1A/50V, la première résistance R10 est une résistance bas niveau 10kΩ 1/4W 50V ou encore le premier condensateur de signal C10 est un condensateur bas niveau 1nF/50V. Ainsi, le circuit de compensation de retards d'initialisation de conduction 82 présente également l'avantage d'être un circuit simple à mettre en oeuvre.

En variante, le premier transistor de signal T10 est un transistor MOSFET canal P. Dès lors, le circuit de compensation de retards d'initialisation de conduction 82 s'active avec un décalage. En effet, dans le cas d'utilisation d'un transistor à effet de champs MOSFET, la plage de fonctionnement de ce type de transistor est comprise entre 2 Volts et 20 Volts alors qu'un transistor bipolaire PNP fonctionne selon une plage de tension définie entre 0 Volts et 20 Volts. Dès lors, il est nécessaire de fonctionner avec des tensions plus élevées entre grille *g'* et l'émetteur *e'.*

Le premier transistor de signal T10 de type MOSFET comprend une source *e*_{*T*10}. Le premier transistor de signal T10 comrpend une grille *b*_{*T*10}. Et le premier transistor de signal T10 comprend un drain *c*_{*T*10} relié à la grille g' du transistor de puissance 60.

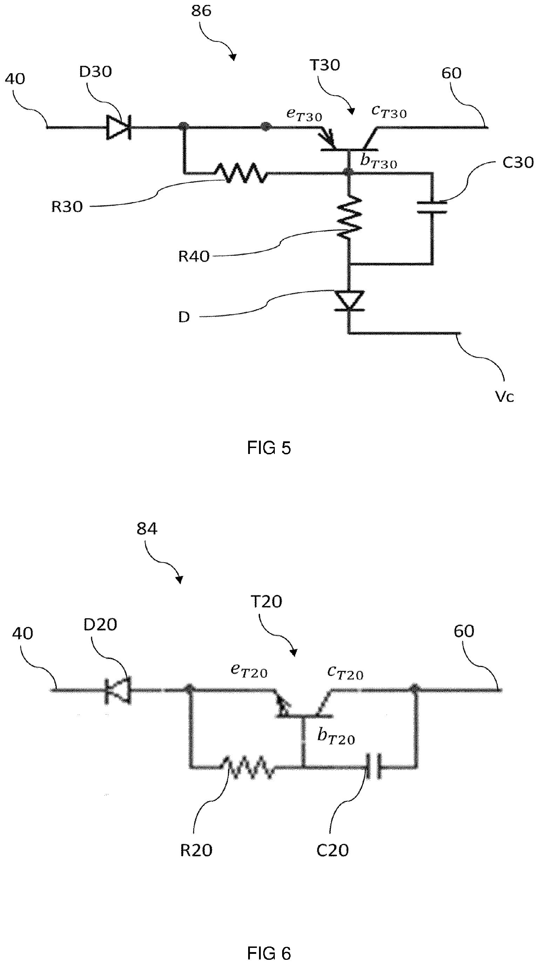

La figure 5 représente le circuit de compensation de retards 86 liés à la charge et/ou la décharge du transistor de puissance 60. Le circuit de compensation de retards 86 comprend une troisième diode de signal D30 configurée pour recevoir, par son anode, le signal de commande du pilote 40. En effet, le circuit de compensation de retards 86 est positionné en dérivation par rapport au circuit de compensation de retards d'initialisation de conduction 82 et par rapport à la résistance de grille *Rg'*.

Le circuit de compensation de retards 86 comprend un troisième transistor de signal T30 relié à la cathode de la troisième diode de signal D30 par l'intermédiaire d'un émetteur du troisième transistor de signal *e*_{*T*30}. Le troisième transistor de signal T30 comprend également une base *b*_{*T*30} et un collecteur *c*_{*T*30} relié à la grille g'du transistor de puissance 60.

De plus, le circuit de compensation de retards 86 comprend une troisième résistance R30 reliée à la base *b*_{*T*30} du troisième transistor de signal T30 et à l'émetteur *e*_{*T*30} du troisième transistor de signal de sorte à être en dérivation par rapport à l'émetteur *e*_{*T*30} du troisième transistor de signal T30 et une diode D reliée, par sa cathode, au collecteur du transistor de puissance 60 et, par son anode, à la base *b*_{*T*30} du troisième transistor de signal T30 par l'intermédiaire d'un troisième condensateur de signal C30 et d'une quatrième résistance R40, le troisième condensateur de signal C30 et la quatrième résistance R40 étant positionnés en dérivation l'un par rapport à l'autre.

En outre, la diode D permet d'informer lorsque le transistor de puissance 60 est dans un état de saturation. En effet, les caractéristiques physiques de la diode D, énoncées ci-après, permet à la diode D de devenir conductrice lorsque le transistor de puissance 60 est saturé. Dès lors, la diode D étant conductrice, un courant circule alors entre la base *b*_{*T*30} du troisième transistor de signal T30 et l'émetteur *e*_{*T*30} du troisième transistor de signal T30 permettant d'observer la dérivation du courant vis-à-vis de la résistance Rg du transistor de puissance 60 et induisant ainsi une rapide augmentation de la tension à la grille Vg, ce qui s'interprète comme une diminution des délais t2' et t5' par rapport aux délais t2 et t5, comme représenté en figure 7.

De manière similaire à la figure 4, le troisième condensateur de signal C30 permet de créer une redirection du courant en direction du troisième transistor de signal T30 afin de dériver le courant de la résistance de grille *Rg'* lors d'une saturation ou d'une désaturation du transistor de puissance 60.

Plus précisément, en réponse au signal de commande est fourni par le pilote 40, la tension à la grille nécessite un temps minimum afin d'évoluer, c'est-à-dire augmenter dans le cas d'une commande pour observer la saturation du transistor de puissance ou diminuer dans le cas d'une commande pour observer une désaturation du transistor de puissance. Ces temps sont représentés par les délais t2, pour le cas d'une commande de saturation du transistor de puissance, et t5, pour le cas d'une commande de désaturation du transistor de puissance.

Cet appel de courant et redirection du courant en direction du circuit de compensation de retards 86 et en direction de la grille *g'* du transistor de puissance 60 permet avantageusement de voir augmenter, ou diminuer, plus rapidement la tension à la grille *g'*du transistor de puissance 60 réduisant ainsi les délais t2, ou t5.

Cet appel de courant et redirection du courant en direction du circuit de compensation de retards 86 et en direction de la grille *g'* du transistor de puissance 60 cesse une fois le troisième condensateur de signal C30 pleinement chargé. De plus, nous pouvons observer qu'avantageusement, lorsque le troisième condensateur de signal C30 est pleinement chargé et que le courant dérivé cesse, la tension mesurée à la grille *g'*du transistor de puissance 60 est une tension équivalente au signal de commande en provenance du pilote 40. Ainsi, la saturation ou la désaturation du transistor de puissance, selon la commande fournie par le pilote 40, est produite dans un délai plus réduit.

En outre, la troisième diode de signal D30, le troisième transistor de signal T30, la troisième résistance R30, la quatrième résistance R40 ainsi que le troisième condensateur de signal C30 sont des composants de faible niveau, c'est-à-dire des composants électroniques simples du marché. A titre d'exemple indicatif, la troisième diode de signal D30 est une diode signal 1A/50V, le troisième transistor de signal T30 est un transistor signal bipolaire PNP 1A/50V, la troisième résistance R30 et la quatrième résistance R40 sont des résistances bas niveau 10kΩ 1/4W 50V ou encore le troisième condensateur de signal C30 est un condensateur bas niveau 1nF/50V. De manière différente, la diode D qui est connecté au collecteur du transistor de puissance 60 doit résister à des tensions plus importantes. De ce fait, la diode D peut être une diode rapide 1A/1000V.

Enfin, de manière similaire à la figure 4, et afin de limiter le délai t4 entre l'initialisation à fermeture du transistor de puissance de la commande du pilote et l'augmentation de la tension au collecteur du transistor de puissance Vc et le délai t6 associé à la diminution de la tension à la grille Vg pour atteindre la valeur minimale Vgmin imposée par la commande du pilote 40, le circuit de compensation de retards d'initialisation d'arrêt de conduction 84 comprend, comme représenté en figure 6, une deuxième diode de signal D20, dont la cathode est connectée au pilote 40, bloquante par rapport au sens du courant en direction de la grille *g'* du transistor de puissance 60.

Le circuit de compensation de retards d'initialisation de d'arrêt de conduction 84 comprend un deuxième transistor de signal T20 relié à l'anode de la deuxième diode de signal D20 par l'intermédiaire d'un émetteur *e*_{*T*20} du deuxième transistor de signal T20. Le deuxième transistor de signal T20 est un transistor bipolaire NPN et comprend également une base *b*_{*T*20} et un collecteur *c*_{*T*20} relié à la grille *g'*du transistor de puissance 60.

Le circuit de compensation de retards d'initialisation de d'arrêt de conduction 84 comprend également une deuxième résistance R20, reliée à l'émetteur *e*_{*T*20} du deuxième transistor de signal T20 et à la base *b*_{*T*20} du deuxième transistor de signal T20 et un deuxième condensateur de signal C20 relié à la base *b*_{*T*20} du deuxième transistor de signal T20 et à la grille *g'*du transistor de puissance 60.

Ainsi, lorsque le pilote 40 fournit une commande d'arrêt de conduction, un différentiel de tension est observable entre la tension à la grille *g'* et les armatures du deuxième condensateur de signal C20. Dès lors, cette différence de tension permet au deuxième condensateur de signal C20 de se charger permettant de réduire le temps nécessaire à la diminution de la tension à la grille *g'* du transistor de puissance 60, c'est-à-dire les délais t4 et t6.

En outre, la deuxième diode de signal D20, le deuxième transistor de signal T20, la deuxième résistance R20 ainsi que le deuxième condensateur de signal C20 sont des composants de faible niveau, c'est-à-dire des composants électroniques simples du marché. A titre d'exemple indicatif, la deuxième diode de signal D20 est une diode signal 1A/50V, le deuxième transistor de signal T20 est un transistor signal bipolaire NPN 1A/50V, la deuxième résistance R20 est une résistance bas niveau 10kΩ 1/4W 50V ou encore le deuxième condensateur de signal C20 est un condensateur bas niveau 1nF/50V. Ainsi, le circuit de compensation de retards d'initialisation d'arrêt de conduction 84 présente également l'avantage d'être un circuit simple à mettre en oeuvre.

En variante, le deuxième transistor de signal T20 est un transistor MOSFET canal N. Dès lors, le circuit de compensation de retards d'initialisation d'arrêt de conduction 84 s'active avec un décalage. En effet, comme dit précédemment, dans le cas d'utilisation d'un transistor à effet de champs MOSFET, la plage de fonctionnement de ce type de transistor est comprise entre 2 Volts et 20 Volts alors qu'un transistor bipolaire NPN fonctionne selon une plage de tension définie entre 0 Volts et 20 Volts. Ainsi, il est nécessaire de fonctionner avec des tensions plus élevées entre grille *g'* et l'émetteur e'.

Le deuxième transistor de signal T20 de type MOSFET comprend un drain *c*_{*T*20}. Le deuxième transistor de signal T20 comprend une grille *b*_{*T*20}. Et le deuxième transistor de signal T20 comprend une source *e*_{*T*20}.

Selon une variante, la première diode de signal D10 et/ou la deuxième diode de signal D20 et/ou la troisième diode de signal D30 sont des diodes Schottky ou des diodes de jonction P-N ou encore des diodes PIN.

De plus, le circuit de compensation des retards 80 présente l'avantage de permettre d'augmenter la fréquence de commutation de du transistor de puissance 60 à grille isolé en réduisant les délais t1, t2, t3, t4, t5 et t6.

Le circuit de compensation des retards 80 présente également l'avantage de permettre de réduire les pertes en conduction en réduisant les délais t2 et t5.

Enfin, la figure 7 représente un chronogramme comparant les retards d'un transistor de puissance en réponse à une commande selon l'état de l'art et les retards d'un transistor de puissance en réponse à une commande selon l'invention. Plus précisément, el chronogramme présente une initialisation de conduction du transistor de puissance soumise par une commande du pilote suivi d'une initialisation d'un arrêt de conduction du transistor de puissance soumise également par un signal de commande du pilote, d'abord selon l'état de l'art et ensuite selon l'invention.

Ainsi, le signal de commande Cde fourni par le pilote 40 prend la forme d'un signal créneau dont le niveau haut induit à une initialisation d'une mise en conduction du transistor de puissance 60 et dont le signal bas induit une initialisation d'un arrêt de la conduction du transistor de puissance. En réponse à ce signal de commande Cde, la tension Vg à la grille *g*'augmente, dans le cas d'une initialisation de conduction, ou diminue, dans le cas d'un arrêt de la conduction du transistor de puissance. Ces initialisations induisent, comme énoncé précédemment, les délais t1, t2, t3, t4, t5, t6. Or, comme visible sur le chronogramme, les délais t1, t2, t3, t4, t5, t6 représentant le retard ou délai pour les actions cités précédemment, à savoir l'initialisation de conduction ou l'arrêt de conduction du transistor de puissance, visible au niveau du collecteur du transistor de puissance par l'intermédiaire de la tension collecteur Vc et du courant collecteur Ic, pour un fonctionnement selon l'état de l'art sont visuellement plus important que les délais t1', t2', t3', t4', t5', t6' présentant les délais nécessaires pour le fonctionnement avec le circuit de compensation de retards 80.

Ainsi, à titre d'exemple indicatif, sans compensation, le temps nécessaire à la mise en conduction du transistor de puissance est équivalent à 456 nanosecondes et le temps nécessaire à l'arrêt de conduction du transistor de puissance est équivalent à 355 nanosecondes. A l'inverse, avec l'action du circuit de compensation des retards 80, le temps nécessaire à la mise en conduction du transistor de puissance est équivalent à 125 nanosecondes et le temps nécessaire à l'arrêt de conduction du transistor de puissance est équivalent à 106 nanosecondes, mettant en lumière une réduction des retards purs cumulés d'environ 580 nanosecondes.

## Revendications

1. Etage de puissance (20) comprenant un transistor de puissance (60) et un pilote (40), le transistor de puissance (60) comprenant un collecteur (*c'*), une grille (*g'*) et un émetteur (*e'*), le transistor de puissance (60) étant configuré pour basculer d'un état dit saturé à un état dit bloqué et vice versa selon une commande du pilote (40), l'étage de puissance (20) comprenant un résistance Rg positionnée entre le pilote (40) et la grille (g') du transistor de puissance (60), l'étage de puissance (20) comprenant un circuit de compensation des retards (80) positionné en dérivation de la résistance Rg, le circuit de compensation des retards (80) comprenant :
- un circuit de compensation de retards d'initialisation de conduction (82), configuré pour dériver le courant la résistance Rg lors d'une initialisation d'une saturation du transistor de puissance (60),
- un circuit de compensation de retards d'initialisation d'arrêt de conduction (84), configuré pour dériver le courant la résistance Rg lors d'une initialisation d'un blocage du transistor de puissance (60),
- un circuit de compensation de retards configuré pour dériver le courant la résistance Rg lorsque le transistor de puissance est proche de l'état saturé (86),
le circuit de compensation de retards d'initialisation de conduction (82) comprenant :
- Une première diode de signal (D10) configurée pour recevoir par son anode un signal de commande du pilote (40),
- Un premier transistor de signal (T10) relié à la cathode de la diode de signal (D10) par l'intermédiaire d'un émetteur ou d'une source (*e*_{*T*10}) du premier transistor de signal (T10), le premier transistor de signal (T10) comprenant une base ou une grille (*b*_{*T*10}), et le premier transistor de signal comprenant un collecteur ou un drain (*c*_{*T*10}) relié à la grille (g') du transistor de puissance (60),
- Une première résistance (R10), reliée à l'émetteur ou à la source (*e*_{*T*10}) du premier transistor de signal (T10), et reliée à la base ou à la grille (*b*_{*T*10}) du premier transistor de signal (T10),
- Un premier condensateur de signal (C10) relié à la base ou à la grille (*b*_{*T*10}) du premier transistor de signal (T10), et à la grille (g') du transistor de puissance (60).

2. Etage de puissance (20) selon la revendication 1, dans lequel le premier transistor de signal (T10) est un transistor bipolaire PNP.

3. Etage de puissance (20) selon la revendication 1, dans lequel le premier transistor de signal (T10) est un transistor MOSFET canal P.

4. Etage de puissance (20) selon l'une des revendications 1 à 3, dans lequel le circuit de compensation de retards d'initialisation de d'arrêt de conduction (84) comprend :
- Un deuxième transistor de signal (T20) relié à la grille (g') du transistor de puissance (60) par l'intermédiaire d'un collecteur ou d'un drain (*c*_{*T*20}) du deuxième transistor de signal (T20), le deuxième transistor de signal (T20) comprenant une base ou une grille (*b*_{*T*20}) et le deuxième transistor de signal (T20) comprenant un émetteur ou une source (*e*_{*T*20}),
- Une deuxième diode de signal (D20) reliée par sa cathode au pilote (40) et reliée par son anode à l'émetteur ou à la source (*e*_{*T*20}) du deuxième transistor de signal (T20),
- Une deuxième résistance (R20), reliée à l'émetteur ou à la source (*e*_{*T*20}) du deuxième transistor de signal (T20) et reliée à la base ou à la grille (*b*_{*T*20}) du deuxième transistor de signal (T20),
- Un deuxième condensateur de signal (C20) relié à la grille (g') du transistor de puissance (60) et relié à la base ou à la grille (*b*_{*T*20}) du deuxième transistor de signal (T20).

5. Etage de puissance (20) selon la revendication 4, dans lequel le deuxième transistor de puissance (T20) est un transistor bipolaire NPN.

6. Etage de puissance (20) selon la revendication 4, dans lequel le deuxième transistor de puissance (T20) est un transistor MOSFET canal N.

7. Etage de puissance (20) selon l'une des revendications 1 à 6, dans lequel le circuit de compensation de retards liés à la charge et/ou la décharge du transistor de puissance (86) comprend :
- Une troisième diode de signal (D30) configurée pour recevoir par son anode un signal de commande du pilote (40),
- Un troisième transistor de signal (T30) relié à la cathode de la troisième diode de signal (D30) par l'intermédiaire d'un émetteur (*e*_{*T*30}) du troisième transistor de signal (T30), le troisième transistor de signal (T30) comprenant une base (*b*_{*T*30}) et un collecteur (*c*_{*T*30}) relié à la grille (g') du transistor de puissance (60),
- Une troisième résistance (R30) reliée à la base (*b*_{*T*30}) du troisième transistor de signal (T30) et à l'émetteur (*e*_{*T*30}) du troisième transistor de signal (T30),
- Une diode (D) reliée par sa cathode au collecteur (c') du transistor de puissance (60) et par son anode à la base (*b*_{*T*30}) du troisième transistor de signal (T30) par l'intermédiaire d'un troisième condensateur de signal (C30) et d'une quatrième résistance (R40), le troisième condensateur de signal (C30) et la quatrième résistance (R40) étant positionnés en dérivation l'un par rapport à l'autre.

## Patentansprüche

1. Leistungsstufe (20), die einen Leistungstransistor (60) und einen Treiber (40) umfasst, wobei der Leistungstransistor (60) einen Kollektor (*c*'), ein Gate (*g*') und einen Emitter (*e*') umfasst, wobei der Leistungstransistor (60) zum Umschalten von einem gesättigt genannten Zustand in einen gesperrt genannten Zustand und umgekehrt gemäß einem Befehl des Treibers (40) konfiguriert ist, wobei die Leistungsstufe (20) einen zwischen dem Treiber (40) und dem Gate (g') des Leistungstransistors (60) positionierten Widerstand Rg umfasst, wobei die Leistungsstufe (20) eine Verzögerungskompensationsschaltung (80) umfasst, die im Nebenschluss zum Widerstand Rg positioniert ist, wobei die Verzögerungskompensationsschaltung (80) Folgendes umfasst:
- eine Schaltung zum Kompensieren von Leitungsinitialisierungsverzögerungen (82), die zum Ableiten des Stroms vom Widerstand Rg bei einer Initialisierung einer Sättigung des Leistungstransistors (60) konfiguriert ist,
- eine Schaltung zum Kompensieren von Leitungsstoppinitialisierungsverzögerungen (84), die zum Ableiten des Stroms vom Widerstand Rg bei einer Initialisierung einer Sperrung des Leistungstransistors (60) konfiguriert ist,
- eine Verzögerungskompensationsschaltung, die zum Ableiten des Stroms vom Widerstand Rg konfiguriert ist, wenn der Leistungstransistor nahe dem Sättigungszustand (86) ist,
wobei die Schaltung zum Kompensieren von Leitungsinitialisierungsverzögerungen (82) Folgendes umfasst:
- eine erste Signaldiode (D10), die zum Empfangen eines Steuersignals des Treibers (40) über ihre Anode konfiguriert ist,
- einen ersten Signaltransistor (T10), der mit der Kathode der Signaldiode (D10) über einen Emitter oder eine Source (*e*_{*T*10}) des ersten Signaltransistors (T10) verbunden ist, wobei der erste Signaltransistor (T10) eine Basis oder ein Gate (*b*_{*T*10}) umfasst und der erste Signaltransistor einen Kollektor oder einen Drain (*c*_{*T*10}) umfasst, der mit dem Gate (g') des Leistungstransistors (60) verbunden ist,
- einen ersten Widerstand (R10), der mit dem Emitter oder der Source (*e*_{*T*10}) des ersten Signaltransistors (T10) verbunden ist und mit der Basis oder dem Gate (*b*_{*T*10}) des ersten Signaltransistors (T10) verbunden ist,
- einen ersten Signalkondensator (C10), der mit der Basis oder dem Gate (*b*_{*T*10}) des ersten Signaltransistors (T10) und mit dem Gate (g') des Leistungstransistors (60) verbunden ist.

2. Leistungsstufe (20) nach Anspruch 1, wobei der erste Signaltransistor (T10) ein PNP-Bipolartransistor ist.

3. Leistungsstufe (20) nach Anspruch 1, wobei der erste Signaltransistor (T10) ein P-Kanal-MOSFET-Transistor ist.

4. Leistungsstufe (20) nach einem der Ansprüche 1 bis 3, wobei die Schaltung zum Kompensieren von Leitungsstoppinitialisierungsverzögerungen (84) Folgendes umfasst:
- einen zweiten Signaltransistor (T20), der über einen Kollektor oder einen Drain (*c*_{*T*20}) des zweiten Signaltransistors (T20) mit dem Gate (g') des Leistungstransistors (60) verbunden ist, wobei der zweite Signaltransistor (T20) eine Basis oder ein Gate (*b*_{*T*20}) und der zweite Signaltransistor (T20) einen Emitter oder eine Source (*e*_{*T*20}) umfasst,
- eine zweite Signaldiode (D20), die über ihre Kathode mit dem Treiber (40) und über ihre Anode mit dem Emitter oder der Source (*e*_{*T*20}) des zweiten Signaltransistors (T20) verbunden ist,
- einen zweiten Widerstand (R20), der mit dem Emitter oder der Source (*e*_{*T*20}) des zweiten Signaltransistors (T20) verbunden ist und mit der Basis oder dem Gate (*b*_{*T*20}) des zweiten Signaltransistors (T20) verbunden ist,
- ein zweiten Signalkondensator (C20), der mit dem Gate (g') des Leistungstransistors (60) verbunden ist und mit der Basis oder dem Gate (*b*_{*T*20}) des zweiten Signaltransistors (T20) verbunden ist.

5. Leistungsstufe (20) nach Anspruch 4, wobei der zweite Leistungstransistor (T20) ein NPN-Bipolartransistor ist.

6. Leistungsstufe (20) nach Anspruch 4, wobei der zweite Leistungstransistor (T20) ein N-Kanal-MOSFET-Transistor ist.

7. Leistungsstufe (20) nach einem der Ansprüche 1 bis 6, wobei die Verzögerungskompensationsschaltung in Bezug auf das Laden und/oder Entladen des Leistungstransistors (86) Folgendes umfasst:
- eine dritte Signaldiode (D30), die zum Empfangen eines Steuersignals vom Treiber (40) über ihre Anode konfiguriert ist,
- einen dritten Signaltransistor (T30), der über einen Emitter (*e*_{*T*30}) des dritten Signaltransistors (T30) mit der Kathode der dritten Signaldiode (D30) verbunden ist, wobei der dritte Signaltransistor (T30) eine Basis (*b*_{*T*30}) und einen Kollektor (*c*_{*T*30}) umfasst, der mit dem Gate (g') des Leistungstransistors (60) verbunden ist,
- einen dritten Widerstand (R30), der mit der Basis (*b*_{*T*30}) des dritten Signaltransistors (T30) und mit dem Emitter (*e*_{*T*30}) des dritten Signaltransistors (T30) verbunden ist,
- eine Diode (D), die über ihre Kathode mit dem Kollektor (c') des Leistungstransistors (60) und über ihre Anode mit der Basis (*b*_{*T*30}) des dritten Signaltransistors (T30) über einen dritten Signalkondensator (C30) und einen vierten Widerstand (R40) verbunden ist, wobei der dritte Signalkondensator (C30) und der vierte Widerstand (R40) im Nebenschluss zueinander positioniert sind.

## Claims

1. A power stage (20) comprising a power transistor (60) and a driver (40), the power transistor (60) comprising a collector (*c*'), a gate (*g*') and an emitter (*e*'), the power transistor (60) being configured to change over from a state referred to as saturated to a state referred to as off and vice versa in accordance with a control from the driver (40), the power stage (20) comprising a resistor Rg positioned between the driver (40) and the gate (g') of the power transistor (60), the power stage (20) comprising a circuit for compensating for delays (80) that is positioned in shunt with the resistor Rg, the circuit for compensating for delays (80) comprising:
- a circuit for compensating for turn-on initialization delays (82), which is configured to divert the current from the resistor Rg when a saturation of the power transistor (60) is initialized,
- a circuit for compensating for turn-off initialization delays (84), which is configured to divert the current from the resistor Rg when a switching-off of the power transistor (60) is initialized,
- a circuit for compensating for delays that is configured to divert the current from the resistor Rg when the power transistor is close to the saturated state (86),
the circuit for compensating for turn-on initialization delays (82) comprising:
- a first signal diode (D10) configured to receive by way of its anode a control signal from the driver (40),
- a first signal transistor (T10) connected to the cathode of the signal diode (D10) via an emitter or a source (*e*_{*T*10}) of the first signal transistor (T10), the first signal transistor (T10) comprising a base or a gate (*b*_{*T*10}), and the first signal transistor comprising a collector or a drain (*c*_{*T*10}) connected to the gate (g') of the power transistor (60),
- a first resistor (R10), connected to the emitter or to the source (*e*_{*T*10}) of the first signal transistor (T10), and connected to the base or to the gate (*b*_{*T*10}) of the first signal transistor (T10),
- a first signal capacitor (C10) connected to the base or to the gate (*b*_{*T*10}) of the first signal transistor (T10), and to the gate (g') of the power transistor (60).

2. The power stage (20) according to claim 1, wherein the first signal transistor (T10) is a PNP bipolar transistor.

3. The power stage (20) according to claim 1, wherein the first signal transistor (T10) is a P-channel MOSFET transistor.

4. The power stage (20) according to one of claims 1 to 3, wherein the circuit for compensating for turn-off initialization delays (84) comprises:
- a second signal transistor (T20) connected to the gate (g') of the power transistor (60) via a collector or a drain (*c*_{*T*20}) of the second signal transistor (T20), the second signal transistor (T20) comprising a base or a gate (*b*_{*T*20}) and the second signal transistor (T20) comprising an emitter or a source (*e*_{*T*20}),
- a second signal diode (D20) connected by way of its cathode to the driver (40) and connected by way of its anode to the emitter or to the source (*e*_{*T*20}) of the second signal transistor (T20),
- a second resistor (R20), connected to the emitter or to the source (*e*_{*T*20}) of the second signal transistor (T20) and connected to the base or to the gate (*b*_{*T*20}) of the second signal transistor (T20),
- a second signal capacitor (C20) connected to the gate (g') of the power transistor (60) and connected to the base or to the gate (*b*_{*T*20}) of the second signal transistor (T20).

5. The power stage (20) according to claim 4, wherein the second power transistor (T20) is an NPN bipolar transistor.

6. The power stage (20) according to claim 4, wherein the second power transistor (T20) is an N-channel MOSFET transistor.

7. The power stage (20) according to one of claims 1 to 6, wherein the circuit for compensating for delays related to the charging and/or discharging of the power transistor (86) comprises:
- a third signal diode (D30) configured to receive by way of its anode a control signal from the driver (40),
- a third signal transistor (T30) connected to the cathode of the third signal diode (D30) via an emitter (*e*_{*T*30}) of the third signal transistor (T30), the third signal transistor (T30) comprising a base (*b*_{*T*30}) and a collector (*c*_{*T*30}) connected to the gate (g') of the power transistor (60),
- a third resistor (R30) connected to the base (*b*_{*T*30}) of the third signal transistor (T30) and to the emitter (*e*_{*T*30}) of the third signal transistor (T30),
- a diode (D) connected by way of its cathode to the collector (c') of the power transistor (60) and by way of its anode to the base (*b*_{*T*30}) of the third signal transistor (T30) via a third signal capacitor (C30) and a fourth resistor (R40), the third signal capacitor (C30) and the fourth resistor (R40) being positioned in shunt with one another.
